# EUROPÄISCHE PATENTANMELDUNG

(11) **EP 4 386 816 A1**
(43) Veröffentlichungstag der Anmeldung: **19.06.2024**
(21) Anmeldenummer: 23211143.5
(22) Anmeldetag: 21.11.2023
(51) Int. Cl.: H01L 21/48, H01L 23/373, H01L 23/473

(54) **VERFAHREN ZUR HERSTELLUNG EINER KÜHLVORRICHTUNG, KÜHLVORRICHTUNG UND BAUGRUPPE**

(30) Priorität: 13.12.2022 DE 102022213549
(71) Anmelder: Robert Bosch GmbH, 70442 Stuttgart (DE)
(72) Erfinder: Holz, Rainer, 71672 Marbach (DE); Klemm, Alexander, 71277 Rutesheim (DE); Frank, Alexander, 71083 Herrenberg (DE); Leibbrand, Harald, 71254 Ditzingen (DE); Maul, Steven, 70563 Stuttgart (DE)

(57) **Zusammenfassung**

Die Erfindung betrifft ein Verfahren zur Herstellung einer Kühlvorrichtung (12) für ein elektronisches Bauteil und/oder eine elektronische Baueinheit (28), wobei die Kühlvorrichtung (12) eine metallische Kühlstruktur (14) und einen Grundkörper (16) umfasst, wobei die metallische Kühlstruktur (14) und der Grundkörper (16) über eine fluiddichte Fügeverbindung derart verbunden werden, dass die metallische Kühlstruktur (14) und der Grundkörper (16) einen Hohlraum (18) zur Aufnahme eines Kühlfluids (20) ausbilden, wobei die fluiddichte Fügeverbindung als eine fluiddichte Metall-Kunststoff-Fügeverbindung (22) hergestellt wird. Ferner betrifft die Erfindung eine durch das Verfahren hergestellte Kühlvorrichtung (12) zur Kühlung zumindest eines elektronischen Bauteils und/oder einer elektronischen Baueinheit (28), sowie eine Baugruppe (10).

## Beschreibung

### Stand der Technik

Die Erfindung betrifft ein Verfahren zur Herstellung einer Kühlvorrichtung für ein elektronisches Bauteil und/oder eine elektronische Baueinheit, eine Kühlvorrichtung zur Kühlung zumindest eines elektronischen Bauteils und/oder einer elektronischen Baueinheit und eine Baugruppe mit einer Kühlvorrichtung.

Aus der DE 10 2011 119 755 A1 ist eine Kühlvorrichtung zum Kühlen einer Anzahl von zu kühlenden Einheiten bekannt, wobei die Kühlvorrichtung einen Kühlkörper und einen Verdrängungskörper aufweist.

### Offenbarung der Erfindung

### Vorteile der Erfindung

Das erfindungsgemäße Verfahren zur Herstellung einer Kühlvorrichtung für ein elektronisches Bauteil und/oder eine elektronische Baueinheit, wobei die Kühlvorrichtung eine metallische Kühlstruktur und einen Grundkörper umfasst, wobei die metallische Kühlstruktur und der Grundkörper über eine fluiddichte Fügeverbindung derart verbunden werden, dass die metallische Kühlstruktur und der Grundkörper einen Hohlraum zur Aufnahme eines Kühlfluids ausbilden, wobei die fluiddichte Fügeverbindung als eine fluiddichte Metall-Kunststoff-Fügeverbindung hergestellt wird, hat demgegenüber den Vorteil, dass dies ein technisch zuverlässiges und kostengünstig zu fertigendes Konstruktionsprinzip für die Kühlung einer elektronischen Baueinheit oder von elektronischen Bauteilen, insbesondere von Leistungshalbleiterbauelementen, ist.

Besonders vorteilhaft ist ein Verfahren, bei dem der Grundkörper aus Kunststoff ist, wobei der Grundkörper aus Kunststoff mit der metallischen Kühlstruktur über die fluiddichte Metall-Kunststoff-Fügeverbindung verbunden wird. Eine derart hergestellte Kühlvorrichtung und die Baugruppe haben den Vorteil, dass die Kühlvorrichtung kostengünstig hergestellt werden kann, da für den Grundkörper mit einem Kunststoff, insbesondere einem thermoplastischen Kunststoff, ein preiswertes Kühlkörpermaterial zur Verfügung steht. Ferner hat die Verwendung von Kunststoff beim Grundkörper den Vorteil, dass dadurch eine einfache und flexible Kühlkörperkonstruktion und Kühlkörpermontage gewährleistet ist. Ein weiterer Vorteil besteht darin, dass die Gestalt der Kühlvorrichtung einfach an die jeweiligen Einsatzbedingungen oder die Einbausituation angepasst werden kann. Zudem weist eine derartige Kühlvorrichtung eine gute Kühlleistung auf. Vorzugsweise ist der Kunststoff derart gewählt, dass der Wärmeausdehnungskoeffizient an den Wärmeausdehnungskoeffizient des Metalls der Kühlstruktur angepasst ist, insbesondere im Wesentlichen dessen entspricht. Dies hat den Vorteil, dass keine mechanischen Spannungen zwischen der Kühlstruktur und dem Grundkörper auftreten, so dass die temperaturabhängige Krümmung oder Wölbung des Kühlkörpers minimiert oder verhindert wird. Vorzugsweise ist der Kunststoff Polyamid, beispielsweise PA 66, vorzugsweise mit verschiedenen Füllgraden und/oder Polypropylen. Polyamid hat den Vorteil, dass dieser Kunststoff kurzfristig bei bis zu 240 °C Einsatztemperatur verwendet werden. Diese hohe Temperaturbeständigkeit des Grundkörpers ermöglicht auch wärmeintensive Prozesse wie beispielsweise Löten (240 °C) und Sintern (200 °C) als Fügeprozesse bei einer nachfolgenden Montage der elektronischen Baueinheit und/oder des elektronischen Bauteils auf die bereits hergestellte Kühlvorrichtung.

Vorteilhaft ist anderseits ein Verfahren, bei dem der Grundkörper aus Metall ist, wobei ein Formteil aus Kunststoff zwischen dem Grundkörper aus Metall und der metallischen Kühlstruktur angeordnet wird, wobei der Grundkörper aus Metall mit dem Formteil aus Kunststoff über die fluiddichte Metall-Kunststoff-Fügeverbindung verbunden wird und/oder die metallische Kühlstruktur mit dem Formteil aus Kunststoff über die fluiddichte Metall-Kunststoff-Fügeverbindung verbunden wird. Dies hat den Vorteil, dass die Kühlung nochmals verbessert wird, da der Grundkörper aus Metall ein guter Wärmeleiter ist.

Vorteilhaft ist ferner ein Verfahren, bei dem zur Herstellung der fluiddichten Metall-Kunststoff-Fügeverbindung eine Oberfläche des Metalls und eine Oberfläche des Kunststoffs strukturiert werden und die Fügeverbindung durch Zusammenpressen der strukturieren Oberfläche des Metalls mit der strukturierten Oberfläche des Kunststoffs hergestellt wird. Eine derartige Metall-Kunststoff-Fügeverbindung ist einfach und ohne zusätzlich Stoffe durchführbar. Gleichzeitig wird durch diese Verbindungsart eine gute Fluiddichtigkeit erreicht.

Besonders vorteilhaft ist ferner ein Verfahren, bei dem zumindest eine weitere Metall-Kunststoff-Fügeverbindung, insbesondere die beschriebene Anpressverbindung, zwischen der metallischen Kühlstruktur und dem Grundkörper innerhalb des Holraumes hergestellt wird. Vorteilhaft ist dabei ein Verfahren, bei dem die weitere Metall-Kunststoff-Fügeverbindung zwischen einer Kühlrippe der metallischen Kühlstruktur und einer Innenwandung des Grundkörpers innerhalb des Hohlraumes hergestellt wird. Dies hat den Vorteil, dass die so hergestellte Kühlvorrichtung mechanisch stabiler ist. Diese erhöhte mechanische Stabilität ermöglicht es zudem, dass für die nachgelagerte Montage der elektronischen Baueinheiten oder der elektronischen Bauteile auch Fügeverfahren, wie beispielsweise Sintern, eingesetzt werden, die eine vertikale Krafteinwirkung erfordern. In einer Variante wird die metallische Kühlrippe mit einem metallischen Grundkörper mittels eines weiteren, zwischen der Kühlrippe und dem Grundkörper angeordneten Formteils aus Kunststoff derart verbunden, dass der Grundkörper aus Metall mit dem Formteil aus Kunststoff über eine fluiddichte Metall-Kunststoff-Fügeverbindung verbunden wird und die metallische Kühlrippe der Kühlstruktur mit dem Formteil aus Kunststoff über die fluiddichte Metall-Kunststoff-Fügeverbindung verbunden wird.

Vorteilhaft ist ferner ein Verfahren, bei dem das zumindest eine elektronische Bauteil und/oder die elektronische Baueinheit mit der metallischen Kühlstruktur und/oder mit dem Grundkörper thermisch leitfähig verbunden wird. Vorzugsweise werden das elektronische Bauteil und/oder die elektronische Baueinheit vor Herstellung der Metall-Kunststoff-Fügeverbindung mit der Kühlstruktur und/oder dem Grundkörper verbunden. In einer Variante wird erst die Metall-Kunststoff-Fügeverbindung hergestellt und dann das elektronische Bauteil und/oder die elektronische Baueinheit mit der Kühlstruktur und/oder dem Grundkörper verbunden.

Die Erfindung betrifft ferner eine Kühlvorrichtung zur Kühlung zumindest eines elektronischen Bauteils und/oder einer elektronischen Baueinheit, wobei die Kühlvorrichtung vorzugsweise durch das vorstehend beschriebene Verfahren hergestellt wird, wobei die Kühlvorrichtung eine metallische Kühlstruktur und einen Grundkörper umfasst, wobei die metallische Kühlstruktur und der Grundkörper über eine fluiddichte Fügeverbindung derart verbunden sind, dass die metallische Kühlstruktur und der Grundkörper einen Hohlraum zur Aufnahme eines Kühlfluids ausbilden, wobei die fluiddichte Fügeverbindung eine fluiddichte Metall-Kunststoff-Fügeverbindung ist. Besonders vorteilhaft ist dabei, dass der Grundkörper aus Kunststoff und vorzugsweise ein Spritzguss, insbesondere ein thermoplastischer Spritzguss, ist. Vorzugsweise ist der Kunststoff Polyamid und/oder Polypropylen. Vorzugsweise ist der Grundkörper topfförmig und/oder die Kühlstruktur deckelförmig ausgebildet. Ein Grundkörper aus Spritzguss ist besonders für die Massenproduktion geeignet und bietet eine hohe Flexibilität bezüglich der Gestaltung der inneren Struktur zur gezielten Strömungsführung des Kühlmediums und der Gestaltung der Anschlüsse für den Zu- und Abfluss des Kühlfluids. Vorzugsweise umfasst der Grundkörper der Kühlvorrichtung eine Einströmöffnung für das Kühlfluid und/oder eine Ausströmöffnung für das Kühlfluid. Gerade bei Ausführung des Grundkörpers als thermoplastischer Spritzguss sind die Einströmöffnung und die Ausströmöffnung einfach herstellbar. Vorzugsweise ist die metallische Kühlstruktur aus Aluminium und/oder eine Aluminiumlegierung und/oder Kupfer und/oder eine Kupferlegierung oder umfasst diese. In einer Variante ist die Kühlstruktur als metallischer Rahmen ausgebildet, wobei die elektronischen Baueinheiten in den metallischen Rahmen vor oder nach der Herstellung der Metall-Kunststoff Fügeverbindung eingesetzt und thermisch kontaktiert werden.

Die Erfindung betrifft ferner eine Baugruppe, wobei die Baugruppe zumindest ein elektronisches Bauteil und/oder eine elektronische Baueinheit und die beschriebene Kühlvorrichtung umfasst, wobei das elektronische Bauteil und/oder die elektronische Baueinheit mit der Kühlvorrichtung thermisch leitend verbunden ist. Vorzugsweise umfasst die Baugruppe ein Kühlfluid. Dabei ist die Baugruppe ausgebildet, das Kühlfluid in dem Hohlraum aufzunehmen und/oder den Hohlraum mit dem Kühlfluid zu durchströmen. Das Kühlfluid ist flüssig oder gasförmig. Das Kühlfluid ist beispielsweise Wasser oder Öl.

Die vorstehend beschriebenen Vorteile für das Verfahren, die Kühlvorrichtung und die Baugruppe gelten entsprechend jeweils wechselseitig.

Weitere Vorteile ergeben sich aus der nachfolgenden Beschreibung von Ausführungsbeispielen mit Bezug zu den Figuren und aus den abhängigen Ansprüchen.

### Kurze Beschreibung der Zeichnungen

Ausführungsbeispiele der Erfindung sind in den Zeichnungen anhand mehrerer Figuren dargestellt und in der nachfolgenden Beschreibung näher erläutert.

Es zeigen:
Fig. 1 eine Schnittdarstellung einer Baueinheit mit einer Kühlvorrichtung gemäß einem ersten Ausführungsbeispiel,
Fig. 2 eine Schnittdarstellung einer Baueinheit mit einer Kühlvorrichtung gemäß einem zweiten Ausführungsbeispiel,
Fig. 3 eine Schnittdarstellung einer Detailansicht einer Baueinheit mit einer Kühlvorrichtung in einer Variante des ersten Ausführungsbeispiels, und
Fig. 4 ein Ablaufdiagramm eines Verfahrens zur Herstellung einer Kühlvorrichtung.

### Beschreibung von Ausführungsbeispielen

Nachfolgend wird ein Verfahren zur Herstellung einer Kühlvorrichtung für ein elektronisches Bauteil und/oder eine elektronische Baueinheit beschrieben, wobei die Kühlvorrichtung eine metallische Kühlstruktur und einen Grundkörper umfasst, wobei die metallische Kühlstruktur und der Grundkörper über eine fluiddichte Fügeverbindung derart verbunden werden, dass die metallische Kühlstruktur und der Grundkörper einen Hohlraum zur Aufnahme eines Kühlfluids ausbilden, wobei die fluiddichte Fügeverbindung als eine fluiddichte Metall-Kunststoff-Fügeverbindung hergestellt wird. Ferner wird eine durch das Verfahren hergestellte Kühlvorrichtung zur Kühlung zumindest eines elektronischen Bauteils und/oder einer elektronischen Baueinheit, sowie eine Baugruppe beschrieben.

Das nachfolgend beschriebene Verfahren nutzt vorzugsweise das aus der DE 10 2019 220 100 A1 bekannte Verfahren zur direkten Metall-Kunststoff-Verbindung für die Herstellung eines Metall-Kunststoff-Verbund-Kühlkörpers. Wie nachfolgend beschrieben sind weitere Verfahren zur Herstellung einer Metall-Kunststoff-Fügeverbindung möglich. Nachfolgend werden drei unterschiedliche Varianten des Verfahrens beschrieben.

In einer ersten Variante des Verfahrens wird eine metallische Kühlstruktur oder ein metallischer Rahmen durch eine Metall-Kunststoff-Fügeverbindung auf einen offenen thermoplastischen Grundkörper aufgesetzt und gasdicht mit diesem verbunden. Anschließend werden die elektronischen Baueinheiten auf die Kühlfläche des so entstandenen Kühlkörpers aufgebracht oder die Baugruppen werden in die Fächer des Rahmens eingesetzt und gasdicht mit diesem verbunden. Der zweite Verfahrensschritt erfolgt durch Löten und/oder Schweißen und/oder Kleben.

In einer zweiten Variante wird die zu kühlende Baugruppe mit direkt angebrachter Kühlstruktur in einen größeren Grundkörper aus Kunststoff eingesetzt und mit diesem durch eine Metall-Kunststoff-Fügeverbindung gasdicht verbunden. Die Verbindungsflächen der zu kühlenden Baugruppe zum Grundkörper bestehen aus einem Werkstoff, der sich strukturieren lässt und bis zu einer mindestens um 20 K höheren Temperatur mechanisch stabil bleibt als der thermoplastische Kunststoff des Grundkörper.

In einer dritten Variante wird ein Leistungselektronikmodul mit direkt angebrachter Kühlstruktur aus Metall in einen größeren Grundkörper aus Metall eingesetzt und mit einer Metall-Kunststoff-Fügeverbindung gasdicht mit diesem verbunden, wobei zwischen beiden Fügeteilen ein Formteil aus Thermoplast liegt, das anschmilzt und sich so gasdicht mit beiden Bauteilen/Baugruppen verbindet.

Der thermoplastische Grundkörper wird vorzugsweise als Spritzgussteil ausgeführt. Vorzugsweise wird die Kühlstruktur so ausgeführt, dass sie nicht nur an ihren Außenrändern, sondern auch in der Mitte mit dem Grundkörper verbunden wird.

In einer weiteren Variante ist der Grundkörper als ein Gehäuseteil der Gesamtbaugruppe ausgebildet. Beispiel ist eine Gesamtbaugruppe, bei der leistungselektronische Komponenten auf der Oberseite des Grundkörpers montiert werden und weniger stark zu kühlende Komponenten auf einer Leiterplatte auf der Unterseite des Grundkörpers Auf der Unterseite wird vorzugsweise ein weiteres Metallteil als Gehäusedeckel mit einer Metall-Kunststoff-Fügeverbindung mit dem Grundkörper verbunden.

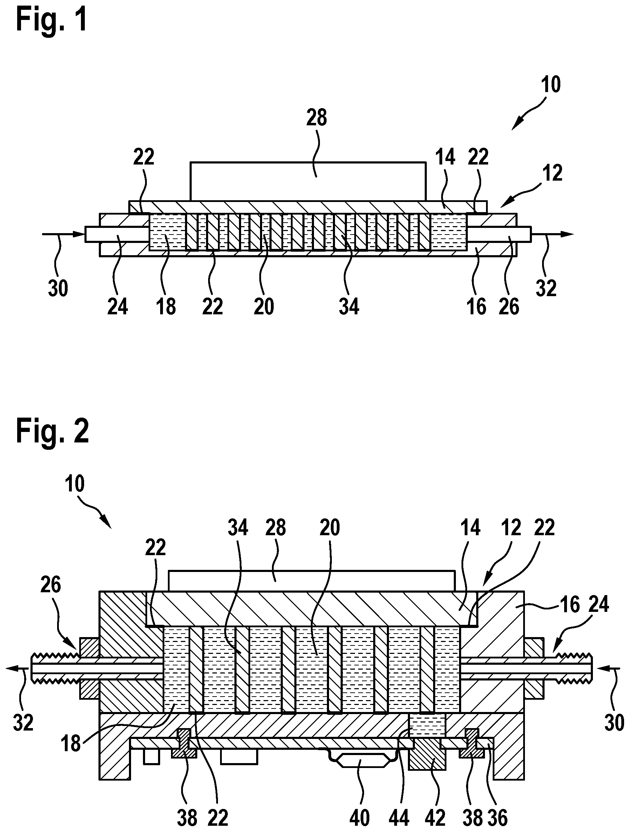

Figur 1 zeigt eine Schnittdarstellung einer Baueinheit 10 mit einer Kühlvorrichtung 12 gemäß einem ersten Ausführungsbeispiel. Die Kühlvorrichtung 12 ist ausgebildet, eine elektronische Baueinheit 28 der Baueinheit 10 zu kühlen. Dabei umfasst die Kühlvorrichtung 12 eine metallische Kühlstruktur 14 und einen thermoplastischen Grundkörper 16. Die Kühlstruktur 14 besteht aus oder umfasst Aluminium. In einer Variante besteht oder umfasst die Kühlstruktur 14 Kupfer. Der thermoplastische Grundkörper 16 besteht oder umfasst Polyamid und/oder Polypropylen. Vorzugsweise ist der thermoplastische Grundkörper 16 als thermoplastischer Spritzguss ausgeführt. Die Kühlstruktur 14 ist an den Rändern der Kühlstruktur 14 mit einem Stirnbereich des Randes des topfförmigen Grundkörper 16 durch eine fluiddichte Metall-Kunststoff-Fügeverbindung 22 verbunden. Die Metall-Kunststoff-Fügeverbindung 22 ist eine Anpressverbindung bei der sowohl eine Oberfläche der metallischen Kühlstruktur 14 in einem Fügebereich als auch eine Oberfläche des thermoplastischen Grundkörpers 16 vor dem Zusammenpressen zumindest bereichsweise strukturiert wurden. Nach der Strukturierung wurden die Kühlstruktur 14 und der Grundkörper 16 zur Herstellung der fluiddichten Metall-Kunststoff-Fügeverbindung 22 gegeneinandergepresst und damit gefügt. Die metallische Kühlstruktur 14 und der Grundkörper 16 sind über die fluiddichte Metall-Kunststoff-Fügeverbindung 22 derart verbunden, dass die metallische Kühlstruktur 14 und der Grundkörper 16 einen Hohlraum 18 zur Aufnahme eines Kühlfluids 20 ausbilden. Die metallische Kühlstruktur 14 umfasst Kühlrippen 34, die innerhalb des Hohlraumes 18 angeordnet sind. Die Kühlrippen 34 bestehen oder umfassen Aluminium und/oder Kupfer. Die Kühlrippen 34 der metallischen Kühlstruktur 14 sind durch eine weitere Metall-Kunststoff-Fügeverbindung 22 mit einer Innenwandung des Grundkörpers 16 verbunden. Die weitere Metall-Kunststoff-Fügeverbindung 22 ist vorzugsweise eine Anpressverbindung bei der sowohl eine Oberfläche der Kühlrippen 34 der metallischen Kühlstruktur 14 in einem Fügebereich als auch eine Oberfläche der Innenwandung des thermoplastischen Grundkörpers 16 vor dem Zusammenpressen zumindest bereichsweise strukturiert wurden. Der Grundkörper 16 umfasst ferner eine Einströmöffnung 24 und eine Ausströmöffnung 26 für ein Kühlfluid 20. Die Kühlvorrichtung 12 und eine elektronische Baueinheit 28 bilden, vorzugsweise zusammen mit dem Kühlfluid, eine Baugruppe 10. Die Baugruppe 10 ist ausgebildet, dass das Kühlfluid 20 bei der Einströmöffnung 24 einströmt 30, durch den Hohlraum 18 zwischen den Kühlrippen 34 der Kühlstruktur 14 hindurchströmt und aus der Ausströmöffnung 26 ausströmt 32. Die elektronische Baueinheit 28 ist auf der Außenseite der metallischen Kühlstruktur 14 mit der Kühlstruktur 14 derart thermisch leitend verbunden, dass die elektronische Baueinheit 28 über die Kühlstruktur 14 und deren Kühlrippen 34 durch das Kühlfluid 20 gekühlt wird.

Figur 2 zeigt eine Schnittdarstellung einer Baueinheit 10 mit einer Kühlvorrichtung 12 gemäß einem zweiten Ausführungsbeispiel. Die Kühlvorrichtung 12 ist ausgebildet, eine elektronische Baueinheit 28, ein elektronisches Bauteil 40 und einen Leistungshalbleiter 42 der Baueinheit 10 zu kühlen. Dabei umfasst die Kühlvorrichtung 12 eine metallische Kühlstruktur 14 und einen thermoplastischen Grundkörper 16. Die Kühlstruktur 14 besteht aus oder umfasst Aluminium. In einer Variante besteht oder umfasst die Kühlstruktur 14 Kupfer. Der thermoplastische Grundkörper 16 besteht oder umfasst Polyamid und/oder Polypropylen. Vorzugsweise ist der thermoplastische Grundkörper 16 als thermoplastischer Spritzguss ausgeführt. Die Kühlstruktur 14 ist an den Rändern der Kühlstruktur 14 mit einem Stirnbereich des Randes des topfförmigen Grundkörper 16 durch eine fluiddichte Metall-Kunststoff-Fügeverbindung 22 verbunden. Die Metall-Kunststoff-Fügeverbindung 22 ist eine Anpressverbindung bei der sowohl eine Oberfläche der metallischen Kühlstruktur 14 in einem Fügebereich als auch eine Oberfläche des thermoplastischen Grundkörpers 16 vor dem Zusammenpressen zumindest bereichsweise strukturiert wurden. Nach der Strukturierung werden die Kühlstruktur 14 und der Grundkörper 16 zur Herstellung der fluiddichten Metall-Kunststoff-Fügeverbindung 22 gegeneinandergepresst und damit gefügt. Die metallische Kühlstruktur 14 und der Grundkörper 16 sind über die fluiddichte Metall-Kunststoff-Fügeverbindung 22 derart verbunden, dass die metallische Kühlstruktur 14 und der Grundkörper 16 einen Hohlraum 18 zur Aufnahme eines Kühlfluids 20 ausbilden. Die metallische Kühlstruktur 14 umfasst Kühlrippen 34, die innerhalb des Hohlraumes 18 angeordnet sind. Die Kühlrippen 34 bestehen oder umfassen Aluminium und/oder Kupfer. Die Kühlrippen 34 der metallischen Kühlstruktur 14 sind durch eine weitere Metall-Kunststoff-Fügeverbindung 22 mit einer Innenwandung des Grundkörpers 16 verbunden. Die weitere Metall-Kunststoff-Fügeverbindung 22 ist vorzugsweise eine Anpressverbindung bei der sowohl eine Oberfläche der Kühlrippen 34 der metallischen Kühlstruktur 14 in einem Fügebereich als auch eine Oberfläche der Innenwandung des thermoplastischen Grundkörpers 16 vor dem Zusammenpressen zumindest bereichsweise strukturiert wurden. Der Grundkörper 16 umfasst ferner eine Einströmöffnung 24 und eine Ausströmöffnung 26 für ein Kühlfluid 20. Die Baugruppe 10 umfasst ferner eine an der Außenseite des Bodens des Grundkörpers 16 angeordnete Leiterplatte 36. Die Leiterplatte 36 ist über Halteklipse 38 mit dem Boden des Grundkörpers 16 kraftschlüssig und thermisch leitfähig verbunden. Auf der Leiterplatte 36 sind elektronische Bauteile 40 angeordnet. Ferner ist auf der Leiterplatte 36t ein Leistungshalbleiterbauelement 42 angeordnet. Der Grundkörper 16 weist im Bereich des Leistungshalbleiterbauelements 42 einen Fluidkanal 44 auf, so dass das Kühlfluid 20 im Hohlraum 18 das Leistungshalbleiterbauelement 42 unmittelbar kühlt. Die Kühlvorrichtung 12, eine elektronische Baueinheit 28, die Leiterplatte 36 mit den elektronischen Bauteilen 40 und dem Leistungshalbleiterbauelement 42 bilden, vorzugsweise zusammen mit dem Kühlfluid, die Baugruppe 10. Die Baugruppe 10 ist ausgebildet, dass das Kühlfluid 20 bei der Einströmöffnung 24 einströmt 30, durch den Hohlraum 18 zwischen den Kühlrippen 34 der Kühlstruktur 14 hindurchströmt und aus der Ausströmöffnung 26 ausströmt 32. Die elektronische Baueinheit 28 ist auf der Außenseite der metallischen Kühlstruktur 14 mit der Kühlstruktur 14 derart thermisch leitend verbunden, dass die elektronische Baueinheit 28 über die Kühlstruktur 14 und deren Kühlrippen 34 durch das Kühlfluid 20 gekühlt wird. Ferner ist die Baugruppe10 ausgebildet, das elektronische Bauteil 40 und den Leistungshalbleiter 42 durch das Kühlfluid 20 zu kühlen.

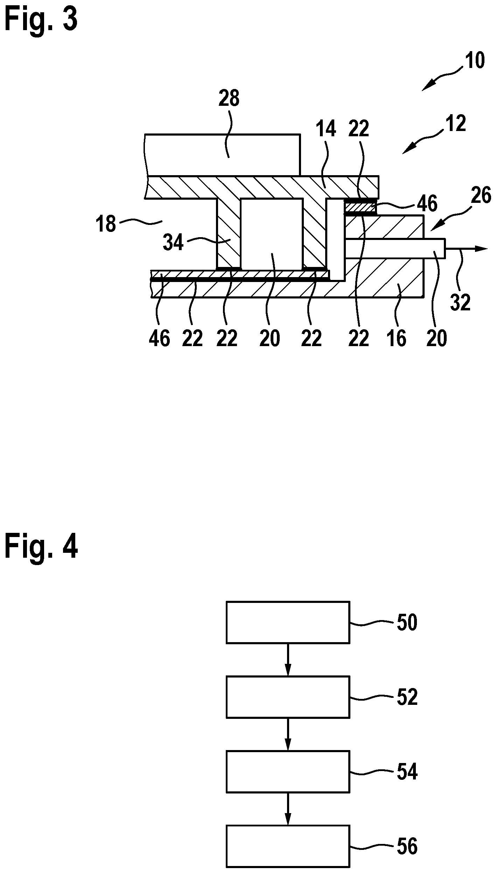

Figur 3 zeigt eine Schnittdarstellung einer Detailansicht einer Baueinheit 10 mit einer Kühlvorrichtung 12 in einer Variante des ersten Ausführungsbeispiels. Die Detailansicht zeigt die rechte Seite der mit Bezug auf die Figur 1 beschriebenen Kühlvorrichtung 12 der Baueinheit 10. In der Variante umfasst die Kühlvorrichtung 12 eine metallische Kühlstruktur 14 und einen metallischen Grundkörper 16. Die Kühlstruktur 14 besteht aus oder umfasst Aluminium. In einer Variante besteht oder umfasst die Kühlstruktur 14 Kupfer. Der metallische Grundkörper 16 besteht aus oder umfasst Aluminium. In einer Variante besteht oder umfasst der metallische Grundkörper 16 Kupfer. Die Figur 3 zeigt eine elektronische Baueinheit 28, die auf der Außenseite der metallischen Kühlstruktur 14 mit der Kühlstruktur 14 thermisch leitend verbunden ist. Ferner zeigt die Figur 3 die Ausströmöffnung 26 zum Ausströmen 32 des Kühlfluids 20 aus dem Hohlraum 18. Ferner umfasst die Kühlstruktur 14 ein Formteil 46 aus Kunststoff. Das Formteil 46 ist im Fügebereich zwischen der Kühlstruktur 14 und dem Grundkörper 16, insbesondere zwischen dem Rand der Kühlstruktur 14 und einem Stirnbereich des Randes des topfförmigen Grundkörpers 16, angeordnet. Das Formteil 46 umfasst oder besteht aus einem thermoplastischen Kunststoff, insbesondere Polyamid und/oder Polypropylen. Die metallische Kühlstruktur 14 ist mit dem Formteil 46 über eine Metall-Kunststoff-Fügeverbindung 22 fluiddicht verbunden. Ferner ist das Formteil 46 über eine Metall-Kunststoff-Fügeverbindung 22 mit dem metallischen Grundkörper 16 fluiddicht verbunden. Damit ist die metallische Kühlstruktur 14 über das Formteil 46 mit dem metallischen Grundkörper 16 durch zwei Metall-Kunststoff-Fügeverbindungen 22 fluiddicht verbunden. Die Metall-Kunststoff-Fügeverbindung 22 ist eine Anpressverbindung bei der sowohl eine Oberfläche der metallischen Kühlstruktur 14 in einem Fügebereich, beide Oberflächen des Formteils 46, als auch eine Oberfläche des metallischen Grundkörpers 16 vor dem Zusammenpressen zumindest bereichsweise strukturiert wurden. Die metallische Kühlstruktur 14 umfasst Kühlrippen 34, die innerhalb des Hohlraumes 18 angeordnet sind. Die Kühlrippen 34 bestehen oder umfassen Aluminium und/oder Kupfer. Die Kühlrippen 34 der metallischen Kühlstruktur 14 sind über ein weiters Formteil 46 durch zwei weitere Metall-Kunststoff-Fügeverbindungen 22 mit einer Innenwandung des metallischen Grundkörpers 16 verbunden. Die weiteren Metall-Kunststoff-Fügeverbindungen 22 sind eine Anpressverbindung bei der sowohl eine Oberfläche der metallischen Kühlstruktur 14, beide Oberflächen des Formteils 46, als auch eine Oberfläche der Innenwandung des metallischen Grundkörpers 16 in einem Fügebereich vor dem Zusammenpressen zumindest bereichsweise strukturiert wurden.

Figur 4 zeigt ein Ablaufdiagramm eines Verfahrens zur Herstellung einer mit Bezug auf die Figuren 1 bis 3 beschriebenen Kühlvorrichtung oder der Baugruppe mit einer Kühlvorrichtung. In einem ersten Verfahrensschritt 50 werden die metallische Kühlstruktur und der Grundkörper bereitgestellt. In einem zweiten Verfahrensschritt 52 wird eine Oberfläche der metallischen Kühlstruktur in einem Fügebereich und eine Oberfläche des Grundkörpers zumindest bereichsweise strukturiert. In einer Variante werden zusätzlich die Oberflächen der Kühlrippen der metallischen Kühlstruktur und die Innenwandung des Grundkörpers strukturiert. Nach der Strukturierung werden in einem dritten Verfahrensschritt 54 die Kühlstruktur und der Grundkörper zur Herstellung der fluiddichten Metall-Kunststoff-Fügeverbindung gegeneinandergepresst und damit gefügt. Gleichzeitig werden auch die Kühlrippen der metallischen Kühlstruktur und die Innenwandung des Grundkörpers durch das Zusammenpressen in Form einer weiteren Metall-Kunststoff-Fügeverbindung gefügt. In einem vierten Verfahrensschritt 56 werden die elektronischen Bauteile und/oder die elektronischen Baueinheiten und/oder die Leistungshalbleiterbauelemente und/oder die Leiterplatten mit den elektronischen Bauteilen mit der Kühlstruktur und/oder dem Grundkörper thermisch leitfähig verbunden. In einer Variante des beschriebenen Verfahrens werden im ersten Verfahrensschritt 50 die metallische Kühlstruktur und der Grundkörper mit bereits vorinstallierten und thermisch verbundenen elektronischen Bauteilen und/oder elektronischen Baueinheiten und/oder Leistungshalbleiterbauelemente und/oder die Leiterplatten bereitgestellt, so dass der vierte Verfahrensschritt 56 entfällt. In einer weiteren Variante wird alternativ oder zusätzlich ein Formteil aus Kunststoff bereitgestellt. In dieser Variante ist der Grundkörper metallisch. Sowohl die Kühlstruktur als auch die metallische Grundkörper und das Formteil werden im zweiten Verfahrensschritt 52 strukturiert. Im dritten Verfahrensschritt 54 werden sowohl zwischen der Kühlstruktur und dem Formteil als auch zwischen dem Formteil und dem metallischen Grundkörper in einem einzigen Verfahrensschritt zwei fluiddichte Metall-Kunststoff-Fügeverbindungen durch zusammenpressen hergestellt.

Vorzugsweise ist die Metall-Kunststoff-Fügeverbindung zwischen der Kühlstruktur und dem Grundkörper und/oder zwischen der Kühlrippe der Kühlstruktur und dem Grundkörper und/oder zwischen der Kühlstruktur und dem Formteil und/oder zwischen dem Formteil und dem Grundkörper eine Anpressverbindung der strukturierten Oberfläche des Metalls und der strukturierten Oberfläche des Kunststoffs. Vorzugsweise werden auf der Oberfläche des Metalls und/oder auf der Oberfläche des Kunststoffs Strukturen, insbesondere Vorsprünge und/oder Hinterschnitte, erzeugt. Vorzugsweise erfolgt die Strukturierung der Oberflächen durch bereichsweises Abtragen von Material, insbesondere mittels mechanischen Bohrens und/oder Fräsens, und/oder mittels Laserablation und/oder mittels chemischen und/oder physikalischen Trockenätzens, und/oder indem die Strukturen mittels eines additiven Fertigungsverfahrens und/oder mittels chemischer oder physikalischer Gasphasenabscheidung auf die Oberflächen aufgebracht werden. Vorzugsweise verformen sich die Strukturen der Fügepartner im Schritt des Aneinanderpressens derart plastisch, dass sich die Strukturen der Oberflächen miteinander verhaken. In einer Variante ist die Metall-Kunststoff-Fügeverbindung eine Klebeverbindung, wobei die Oberfläche des Metalls mit einer von einer Nanostruktur überlagerten Mikrostruktur mittels eines Lasers strukturiert wird. Nach der Strukturierung wird der Kleber aufgetragen und die Fügeverbindung hergestellt. Durch die Strukturierung der Oberfläche des Metalls wird die Fluiddichtigkeit gewährleistet.

## Patentansprüche

1. Verfahren zur Herstellung einer Kühlvorrichtung (12) für ein elektronisches Bauteil (40) und/oder eine elektronische Baueinheit (28), wobei die Kühlvorrichtung (12) eine metallische Kühlstruktur (14) und einen Grundkörper (16) umfasst, wobei die metallische Kühlstruktur (14) und der Grundkörper (16) über eine fluiddichte Fügeverbindung derart verbunden werden, dass die metallische Kühlstruktur (14) und der Grundkörper (16) einen Hohlraum (18) zur Aufnahme eines Kühlfluids (20) ausbilden, wobei die fluiddichte Fügeverbindung als eine fluiddichte Metall-Kunststoff-Fügeverbindung (22) hergestellt wird.

2. Verfahren nach Anspruch 1,
**dadurch gekennzeichnet, dass**
der Grundkörper (16) aus Kunststoff ist, wobei der Grundkörper (16) aus Kunststoff mit der metallischen Kühlstruktur (14) über die fluiddichte Metall-Kunststoff-Fügeverbindung (22) verbunden wird.

3. Verfahren nach Anspruch 1,
**dadurch gekennzeichnet, dass**
der Grundkörper (16) aus Metall ist, wobei ein Formteil (46) aus Kunststoff zwischen dem Grundkörper (16) aus Metall und der metallischen Kühlstruktur (14) angeordnet wird, wobei der Grundkörper (16) aus Metall mit dem Formteil (46) aus Kunststoff über die fluiddichte Metall-Kunststoff-Fügeverbindung (22) verbunden wird und/oder die metallische Kühlstruktur (14) mit dem Formteil (46) aus Kunststoff über die fluiddichte Metall-Kunststoff-Fügeverbindung (22) verbunden wird.

4. Verfahren nach einem der vorhergehenden Ansprüche,
**dadurch gekennzeichnet, dass**
zur Herstellung der fluiddichten Metall-Kunststoff-Fügeverbindung (22) eine Oberfläche des Metalls und eine Oberfläche des Kunststoffs strukturiert werden und die Metall-Kunststoff-Fügeverbindung (22) durch Zusammenpressen der strukturieren Oberfläche des Metalls mit der strukturierten Oberfläche des Kunststoffs hergestellt wird.

5. Verfahren nach einem der vorhergehenden Ansprüche,
**dadurch gekennzeichnet, dass**
zumindest eine weitere Metall-Kunststoff-Fügeverbindung (22) zwischen der metallischen Kühlstruktur (14) und dem Grundkörper (16), insbesondere zwischen einer Kühlrippe (34) der metallischen Kühlstruktur (14) und einer Innenwandung des Grundkörpers (16), innerhalb des Hohlraumes (18) hergestellt wird.

6. Kühlvorrichtung (12) zur Kühlung zumindest eines elektronischen Bauteils (40) und/oder einer elektronischen Baueinheit (28), insbesondere hergestellt durch ein Verfahren nach einem der vorhergehenden Ansprüche, wobei die Kühlvorrichtung (12) eine metallische Kühlstruktur (14) und einen Grundkörper (16) umfasst, wobei die metallische Kühlstruktur (14) und der Grundkörper (16) über eine fluiddichte Fügeverbindung derart verbunden sind, dass die metallische Kühlstruktur (14) und der Grundkörper (16) einen Hohlraum (18) zur Aufnahme eines Kühlfluids (20) ausbilden, wobei die fluiddichte Fügeverbindung eine fluiddichte Metall-Kunststoff-Fügeverbindung (22) ist.

7. Kühlvorrichtung (12) nach Anspruch 6,
**dadurch gekennzeichnet, dass**
der Grundkörper (16) aus Kunststoff ist, wobei der Grundkörper (16) aus Kunststoff mit der metallischen Kühlstruktur (14) über die fluiddichte Metall-Kunststoff-Fügeverbindung (22) verbunden ist.

8. Kühlvorrichtung (12) nach Anspruch 7,
**dadurch gekennzeichnet, dass**
der Grundkörper (16) aus Kunststoff ein Spritzguss, insbesondere ein thermoplastischer Spritzguss, ist.

9. Kühlvorrichtung (12) nach Anspruch 6,
**dadurch gekennzeichnet, dass**
der Grundkörper (16) aus Metall ist und die Kühlvorrichtung (12) ein Formteil (46) aus Kunststoff umfasst, wobei das Formteil (46) aus Kunststoff zwischen dem Grundkörper (16) aus Metall und der metallischen Kühlstruktur (14) angeordnet ist, wobei der Grundkörper (16) aus Metall mit dem Formteil (46) aus Kunststoff über die fluiddichte Metall-Kunststoff-Fügeverbindung (22) verbunden ist und/oder die metallische Kühlstruktur (14) mit dem Formteil (46) aus Kunststoff über die fluiddichte Metall-Kunststoff-Fügeverbindung (22) verbunden ist.

10. Kühlvorrichtung (12) nach einem der Ansprüche 6 bis 9,
**dadurch gekennzeichnet, dass**
der Grundkörper (16) eine Einströmöffnung (24) für das Kühlfluid (20) und/oder eine Ausströmöffnung (26) für das Kühlfluid (20) umfasst.

11. Kühlvorrichtung (12) nach einem der Ansprüche 6 bis 10,
**dadurch gekennzeichnet, dass**
die metallische Kühlstruktur (14) und/oder die Kühlrippe (34) der Kühlstruktur (14) aus Aluminium und/oder Kupfer ist oder diese umfasst.

12. Kühlvorrichtung (12) nach einem der Ansprüche 6 bis 11,
**dadurch gekennzeichnet, dass**
zumindest eine weitere Metall-Kunststoff-Fügeverbindung (22) zwischen der metallischen Kühlstruktur (14) und dem Grundkörper (16), insbesondere zwischen einer Kühlrippe (34) der metallischen Kühlstruktur (14) und einer Innenwandung des Grundkörpers (16), innerhalb des Hohlraumes (18) hergestellt wird.

13. Kühlvorrichtung (12) nach einem der Ansprüche 6 bis 12,
**dadurch gekennzeichnet, dass**
die fluiddichte Metall-Kunststoff-Fügeverbindung (22) eine Anpressverbindung eine strukturierte Oberfläche des Metalls und einer strukturierten Oberfläche des Kunststoffs.

14. Baugruppe (10), wobei die Baugruppe (10) zumindest ein elektronisches Bauteil (40) und/oder eine elektronische Baueinheit (28) umfasst,
**gekennzeichnet durch**
eine Kühlvorrichtung (12) nach einem der Ansprüche 6 bis 13, wobei das elektronische Bauteil (40) und/oder die elektronische Baueinheit (28) mit der Kühlvorrichtung (12) thermisch leitend verbunden ist.

15. Baugruppe (10) nach Anspruch 14,
**dadurch gekennzeichnet, dass**
die Baugruppe (10) ein Kühlfluid (20) umfasst, wobei die Baugruppe (10) ausgebildet ist, das Kühlfluid (20) in dem Hohlraum (18) aufzunehmen und/oder den Hohlraum (18) mit dem Kühlfluid (20) zu durchströmen.
